Europäisches Patentamt

**European Patent Office**

**Office européen des brevets**

(19)

(11) Veröffentlichungsnummer: **0 061 049**
**B1**

(12) # EUROPÄISCHE PATENTSCHRIFT

(45) Veröffentlichungstag der Patentschrift:
**23.01.85**

(51) Int. Cl.⁴: **H 03 K 4/83,** H 04 N 3/16

(21) Anmeldenummer: **82101791.0**

(22) Anmeldetag: **06.03.82**

(54) **Ansteuerschaltung für eine geschaltete Vertikal-Ablenkschaltung eines Fernsehempfängers.**

(30) Priorität: **13.03.81 DE 3109611**

(43) Veröffentlichungstag der Anmeldung:
**29.09.82 Patentblatt 82/39**

(45) Bekanntmachung des Hinweises auf die Patenterteilung:
**23.01.85 Patentblatt 85/4**

(84) Benannte Vertragsstaaten:
**BE FR GB IT NL SE**

(56) Entgegenhaltungen:
**EP - A - 0 008 263**
**DE - A - 3 022 267**

(73) Patentinhaber: **Deutsche Thomson-Brandt GmbH,**
**Hermann-Schwer-Strasse 3,**
**D-7730 Villingen-Schwenningen (DE)**

(72) Erfinder: **Hartmann, Uwe, Ing. grad., Tallardstrasse 15,**
**D-7730 Villingen-Schwenningen (DE)**

EP 0 061 049 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die vorliegende Erfindung betrifft eine Ansteuerschaltung für eine geschaltete Vertikal-Ablenkschaltung eines Fernsehgerätes gemäß dem Oberbegriff des Anspruchs 1.

Vertikal-Ablenkschaltungen, die mit Schalter betrieben werden, also im sogenannten Klasse D-Betrieb, sind seit einiger Zeit bekannt, beispielsweise aus der DE-PS 1 289 097. Dieser lag die Forderung zugrunde, die Vertikal-Ablenkschaltung dahingehend zu verbessern, daß in der Endstufe Halbleiter mit einer viel geringeren Verlustleistung verwendbar waren. Dies wurde erreicht, indem eine Umformstufe verwendet wurde zum Umformen der sägezahnförmigen Steuerspannung in Impulsfolgen veränderlicher Breite, der das sägezahnförmige Signal und ein weiteres Signal zugeführt wurde, dessen Frequenz wesentlich höher ist als die Frequenz des sägezahnförmigen Signals, so daß die Breite der Ausgangsimpulse der Umformstufe von der Amplitude der sägezahnförmigen Steuerspannung abhängig ist, und daß die Impulse der Ausgangs- oder Endstufe zugeführt werden, in deren Ausgang ein integrierendes Netzwerk aufgenommen worden ist, das die Vertikal-Ablenkspule enthält. Ein weiteres Kennzeichen dieses Patentes ist es, daß die Frequenz der Impulse gleich der geraden Harmonischen der Zeilenabtastfrequenz ist. Die in der Endstufe verwendeten Halbleiter können, z. B. gesteuerte Gleichrichter oder Transistoren sein, die als Schalter wirksam sind.

Ausgehend hiervon entstand in den letzten Jahren eine geschaltete Vertikal-Ablenkschaltung gemäß der französischen Patentanmeldung 7 822 266, die vom Rücklauf- und Hinlaufsignal der Zeilenabtastung ausgehend arbeitet, das von nur einer Wicklung des Zeilentrafos geliefert wird, wobei die Vertikal-Ablenkschaltung eine Reihenschaltung eines Meßwiderstandes mit einem Verbindungskondensator enthält und letzterer einen solchen Wert besitzt, daß die Spannung an den Anschlüssen dieses Schaltungsteils stets eine von der Richtung des Ablenkstromes unabhängige Polarität besitzt, wobei sich dieses Schaltungsteil sowohl als Generator wie auch als Verbraucher verhält und verbunden ist mit einer Generatorschaltung zur Erzeugung eines Sägezahnsignals, ausgehend vom Rücklaufsignal der Zeilenabtastung mittels der Antiparallelschaltung eines nicht gesteuerten Schalters (Diode) und eines gesteuerten Schalters (Thyristor oder Transistor) und die von einer Steuerschaltung als Treiberstufe gesteuert wird, die rasterfrequent impulsbreitenmoduliert und zeilenfrequent geschaltet wird.

Diese Ablenkschaltung besitzt einige Vorteile. Sie ist preisgünstig, besitzt einen guten Wirkungsgrad und weist keine Übernahmeverzerrungen auf. Nachteilig ist jedoch, daß sie zwei Zustände annehmen kann, die als Störfälle zu bezeichnen sind, von denen aus sie nicht selbsttätig in den geregelten Arbeitsbereich kommen kann. Das ist der Fall, wenn der gesteuerte Schalter andauernd geöffnet oder andauernd durchgeschaltet bleibt. Im ersten Fall würde Spitzengleichrichtung durch den nicht gesteuerten Schalter (Diode) der hohen, horizontalfrequenten Spannung stattfinden und als Folge davon der genannte Verbindungskondensator erheblich überlastet, da ein Vielfaches seiner Nennspannung auftritt. Dieser Fall kann in bekannter Weise durch Auslösen einer der üblichen Schutzfunktionen des Gesamtgerätes abgesichert werden. Der zweite mögliche Fall, wobei der genannte Schalter andauernd durchgeschaltet bleibt, läßt keine Spannung an dem erwähnten Verbindungskondensator entstehen, wodurch bewirkt wird, daß die Schaltung sozusagen nicht selbst wieder »aufstehen« kann, sie könnte mit anderen Worten nicht wieder automatisch in den normalen, geregelten Arbeitsbereich gelangen. Dieser Fall kann während des Einschaltvorgangs eintreten, wenn beispielsweise Versorgungsspannungen stark voneinander abweichende Zeitkonstanten haben oder wenn man das Gerät oft hintereinander aus- und wieder einschaltet.

Der vorliegenden Erfindung lag die Aufgabe zugrunde, durch eine einfache Schaltungsmaßnahme den genannten zweiten Störfall mit Sicherheit unmöglich zu machen.

Für den angegebenen Oberbegriff des Anspruchs 1 wird diese Aufgabe erfindungsgemäß nach dem Kennzeichen desselben gelöst.

Der zweite Zustand kann mit Sicherheit nicht auftreten, wenn man die Versorgungsspannung für die Treiberschaltung, die den Steuerstrom für den gesteuerten Schalter liefert, beispielsweise über ein RC-Siebglied aus dem Kreis der Vertikal-Endstufe selbst entnimmt. Mit dieser Anordnung ist es unmöglich, daß der gesteuerte Schalter immer geschlossen bleibt, da dann die Treiberschaltung keine Betriebsspannung hätte. Der Widerstand des Siebgliedes stellt gleichzeitig eine Dämpfung für die Ablenkspule dar.

Überraschenderweise hat diese Anordnung einen weiteren Vorteil, wenn man als Abschaltkriterium für den zuerst genannten Fall, bei welchem der gesteuerte Schalter geöffnet bleibt, die Spannung an dem Siebkondensator benutzt. In dieser Weise wird eine Unterbrechung in der Ablenkspule ebenfalls erfaßt und das Gerät auch für diesen Fehlerfall geschützt.

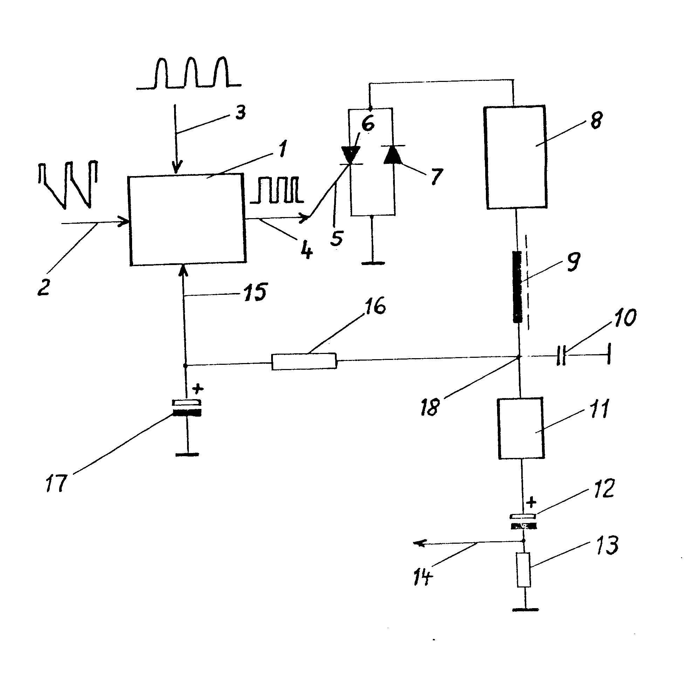

Die Erfindung wird nachstehend anhand der einzigen Figur beschrieben, die in der Art einer Blockschaltung die Funktionsweise einer Ablenkstufe und die Ansteuerschaltung für die Treiberschaltung sowie ihren Anschluß an den Schaltkreis der Vertikal-Endstufe zeigt.

Die Treiberschaltung 1 hat drei Eingänge. Am Eingang 2 liegt ein rasterfrequentes Signal, das in der Treiberschaltung 1, die gleichzeitig als Modulator arbeitet, in ein impulsbreitenmoduliertes Signal verwandelt wird, indem der Modulator durch ein am Eingang 3 liegendes zeilenfrequentes Signal geschaltet wird. Somit liefert der Ausgang 4 einen impulsbreitenmodulierten Strom an das Gate 5 des Thyristors 6, der diesen Impulsen entsprechend durchgeschaltet wird. Antiparallel zu dem Thyristor 6 liegt eine Diode 7. Die Bauteile 6 und 7 bilden in Reihenschaltung mit einer Wicklung auf dem Zeilentransformator 8 und einem aus einer Drossel 9 und einem Kondensator 10 bestehenden Integrierglied die Vertikal-Endstufe. Die Vertikal-Ablenkschaltung besteht aus der Reihenschaltung der Vertikal-Ablenkspule 11, einem Verbindungskondensator 12 und einem Meßwiderstand 13 nach Masse. Am Verbindungspunkt 14 des Kondensators 12 mit dem Meßwiderstand 13 wird eine Gegenkopplungsspannung abgenommen. Der Kondensator 12 hat einen solchen Wert, daß die Spannung an den Anschlüssen desselben stets eine von der Richtung des Ablenkstromes unabhängige Polarität besitzt, d. h. er wird nie ganz entladen oder gar umgekehrt aufgeladen. Er verhält sich sowohl als Generator wie auch als Verbraucher und ist mit der aus den Bauteilen 8, 9 und 10 bestehenden Generatorschaltung zur Erzeugung eines Sägezahnstromes über die Vertikal-Ablenkspule 11 verbunden. Diese Generatorschaltung erzeugt den Sägezahnstrom ausgehend vom Rücklauf- und Hinlaufsignal der Zeilenabtastung mittels der Antiparallelschaltung einer Diode 7 und eines Thyristors 6. Letzterer wird wie bereits erwähnt, von einer Steuerschaltung als Treiberschaltung 1 gesteuert, an deren Eingang 15 eine Versorgungsspannung liegt, die aus der Endstufe über eine entsprechende Ankopplung, z. B. über ein RC-Glied bestehend aus dem Widerstand 16 und dem Kondensator 17, unmittelbar am Anschlußpunkt 18 entnommen wird. Das zuletzt beschriebene RC-Glied oder eine andere entsprechende Ankopplung verhindern zwei ansonsten mögliche Störfälle oder Zustände, von denen aus die Schaltung nicht in den geregelten Arbeitsbereich kommen könnte. Diese beiden Zustände würden nämlich entstehen, wenn entweder der gesteuerte Schalter, der Thyristor 6, andauernd geöffnet oder andauernd durchgeschaltet bliebe.

Der erste Zustand würde Spitzengleichrichtung durch die Diode 7 der hohen, horizontalfrequenten Spannung zur Folge haben und an dem Verbindungskondensator 12 eine ihn zerstörende Spannung entstehen lassen. Dieser Fall kann in bekannter Weise durch Auslösen der Schutzfunktion des Gesamtgerätes abgedeckt werden. Das läßt sich vorteilhaft erreichen, indem die am Anschluß 15 entstehende Spannung als Abschaltkriterium benutzt wird.

Beim Eintreten des zweiten Zustandes entsteht keine Spannung am Verbindungskondensator 12, und die Schaltung kann nicht in ihre normale Arbeitsweise »aufstehen«. Dieser Fall könnte während des Einschaltvorgangs eintreten, wenn z. B. Versorgungsspannungen stark voneinander abweichende Zeitkonstanten haben oder wenn man das Gerät oft hintereinander aus- und wieder einschaltet. Dieser Zustand wird durch die beschriebene Ankopplung mit Sicherheit verhindert, indem es unmöglich ist, daß der gesteuerte Schalter immer geschlossen bleibt, da in diesem Fall die Treiberschaltung keine Betriebsspannung hätte. Der Widerstand 16 stellt gleichzeitig eine vorteilhafte Dämpfung für die Vertikal-Ablenkspule 11 dar.

Bei einer praktisch ausgeführten und erprobten Schaltung wurden folgende Werte für die zuvor aufgeführten Bauteile verwendet:

| | |
|---|---|
| Kondensator 10 | 47 µF |
| Kondensator 12 | 470 µF |
| Kondensator 17 | 47 µF |
| Widerstand 13 | 2,2 Ohm |
| Widerstand 16 | 2,2 k-Ohm |
| Drossel 9 | 380 µH |

## Patentansprüche

1. Ansteuerschaltung für eine geschaltete Vertikal-Ablenkschaltung eines Fernsehempfängers, die vom Rücklauf- und Hinlaufsignal der Zeilenabtastung ausgehend arbeitet, das von nur einer Wicklung des Zeilentrafos (8) geliefert wird, wobei die Vertikal-Ablenkschaltung eine Reihenschaltung eines Meßwiderstandes (13) mit einem Verbindungskondensator (12) enthält und letzterer einen solchen Wert besitzt, daß die Spannung an den Anschlüssen dieses Schaltungsteils stets eine von der Richtung des Ablenkstromes unabhängige Polarität besitzt, wobei sich dieses Schaltungsteil sowohl als Generator als auch als Verbraucher verhält und verbunden ist mit einer Vertikalendstufe (6—10), die eine Generatorschaltung (8—10) umfaßt, die vom Rücklauf- und Hinlaufsignal der Zeilenabtastung ausgehend mittels der Antiparallelschaltung einer Diode (7) und eines gesteuerten Schalters (z. B. Thyristor (6) bzw. Transistor) einen Sägezahnstrom erzeugt und die von einer Steuerschaltung als Treiberstufe (1) gesteuert wird, die rasterfrequent impulsbreitenmoduliert und zeilenfrequent geschaltet wird, dadurch gekennzeichnet, daß die Versorgungsspannung für die Treiberschaltung, die den Steuerstrom (4) für den gesteuerten Schalter (z. B. Thyristor (6)) liefert, über eine entsprechende Ankopplung unmittelbar aus der Vertikalendstufe entnommen wird.

2. Ansteuerschaltung nach Anspruch 1, dadurch gekennzeichnet, daß der Anschluß (15) der Versorgungsspannung für die Treiberschaltung (1) außerdem mit einer an sich bekannten Schutzschaltung des Gesamtgerätes verbunden ist, so daß der Störfall eines geöffnet bleibenden gesteuerten Schalters (z. B. Thyristors) abgesichert ist, indem die dann anstehende Spannung an dem genannten Anschluß der Versorgungsspannung für die Treiberschaltung als Abschaltkriterium dient.

3. Ansteuerschaltung nach Anspruch 1, dadurch gekennzeichnet, daß die Versorgungsspannung für die Treiberschaltung über ein RC-Glied (16, 17) abgenommen wird, indem der Widerstand (16) zwischen dem Anschlußpunkt (18) der Vertikal-Ablenkspule (11) an die Vertikalendstufe und dem Emitter eines als Treiberstufe arbeitenden PNP-Transistors liegt und der Kondensator (17) den Emitteranschluß mit Masse verbindet.

**Claims**

1. Trigger circuit for a switched vertical deflection circuit of a television receiver, which starts-out to work from the fly-back-and trace-signal of the line scanning, which is delivered by only one winding of the line transformer (8), whereby the vertical deflection circuit contains a series circuit of a measuring resistor (13) with a connecting capacitor (12) and the latter has such a value, that the voltage at the terminals of this means possesses always a polarity independant of the direction of the deflection current, whereby this means behaves as well as generator as also as load and is connected with a vertical final stage (6—10), which encloses a generator circuit (8—10), which, starting out from the fly-back-and trace-signal of the line scanning, by means of an antiparallel circuit of a diode (7) and a controlled switch (f. i. Thyristor (6) resp. Transistor) generates a saw-tooth current and which is controlled by a control-circuit as driver-stage (1), which is being frame frequency-like pulse-width-modulated and line frequency-like switched, characterized in that the supply voltage for the driver circuit, which furnishes the control current (4) for the controlled switch (f. i. Thyristor (6)), is being taken directly from the vertical final stage via a appropriate coupling.

2. Trigger circuit according to claim 1, characterized in that the terminal (15) of the supply voltage for the driver circuit is connected additionally with a as such known protecting circuit of the complete set in such a way, that the interference case of a open remaining, controlled switch (f. i. Thyristor) is being protected, while the voltage just then existing at said terminal of the supply voltage for the driver circuit is being used as turn-off criterion.

3. Trigger circuit according to claim 1, characterized in that the supply voltage for the driver circuit is taken via a RC-member (16, 17), while the resistor (16) is positioned between the terminalpoint (18) of the vertical deflection coil (11) at the vertical final stage and the emitter of a PNP-Transistor, working as driver stage, and the capacitor (17) connects the emitter terminal with ground.

**Revendications**

1. Circuit de commande d'un circuit commuté de déviation verticale d'un récepteur de télévision, qui agit en fonction du signal d'aller et de retour du balayage de lignes, qui est fourni par seulement un enroulement du transformateur de lignes (8), le circuit de déviation verticale comprenant une combinaison-série d'une résistance de mesure (13) et d'un condensateur de liaison (12) et ce dernier ayant une valeur telle que la tension aux bornes de cette partie de circuit présente constamment une polarité indépendante du sens du courant de déviation, cette partie de circuit se comportant aussi bien comme une partie génératrice que comme une partie consommatrice et étant reliée à un étage final vertical (6—10), qui comporte un circuit générateur (8—10), qui produit en fonction du signal d'aller et de retour du balayage de lignes, au moyen de la combinaison antiparallèle d'une diode (7) et d'un commutateur commandé (par exemple un thyristor (6) ou un transistor) un courant en dents de scie et qui est commandé par un circuit de commande agencé comme un étage pilote (1), qui est modulé en largeur d'impulsions à la fréquence de trame et qui est commuté à la fréquence de lignes, caractérisé en ce que la tension d'alimentation du circuit pilote, qui fournit le courant de commande (4) du commutateur commandé (par exemple un thyristor (6)), est prise directement à l'étage final vertical par l'intermédiaire d'un couplage correspondant.

2. Circuit de commande selon la revendication 1, caractérisé en ce que la prise (15) de la tension d'alimentation pour le circuit pilote (1) est en outre reliée à un circuit de protection, connu en soi, de l'ensemble de l'appareil de manière à obtenir une protection contre le cas de panne d'un commutateur commandé (par exemple un thyristor) restant ouvert, par le fait que la tension existant alors à la prise précitée de la tension d'alimentation pour le circuit pilote sert de critère de coupure.

3. Circuit de commande selon la revendication 1, caractérisé en ce que la tension d'alimentation du circuit pilote est prise par l'intermédiaire d'un composant RC (16, 17), dans lequel la résistance (16) est branchée entre le point de jonction (18) de la bobine de déviation verticale (11) avec l'étage final vertical, et l'émetteur d'un transistor PNP opérant comme un étage pilote et le condensateur (17) relie la jonction d'émetteur à la masse.